# FASCICULE DE BREVET EUROPEEN

(11) **EP 2 371 760 B1**
(45) Date de publication et mention de la délivrance du brevet: **11.01.2017**
(21) Numéro de dépôt: 11160729.7
(22) Date de dépôt: 31.03.2011
(51) Int. Cl.: B81B 7/00

(54) **Boitier d'encapsulation sous vide de microsysteme éléctromécanique, ensemble associe, et procéde de détéction d'un probleme de brasure dans un tel ensemble**
Vakuum-Einkapselungsgehäuse eines elektromechanischen Mikrosystems, entsprechende Einheit und Erfassungsverfahren eines Lötproblems in einer solchen Einheit
Housing for vacuum encapsulation of an electromechanical microsystem, associated assembly and method for detecting a solder problem in such an assembly

(30) Priorité: 02.04.2010 FR 1001395
(43) Date de publication de la demande: 05.10.2011
(73) Titulaire: Thales, 92400 Courbevoie (FR)
(72) Inventeur: Leverrier, Bertrand, 26120 Montelier (FR); Leduc, Dominique, 35200 Rennes (FR)
(74) Mandataire: Brunelli, Gérald

(56) Documents cités:
- US-A1- 2005 167 789
- US-A1- 2007 159 803

## Description

La présente invention porte sur un boîtier d'encapsulation sous vide de microsystème électromécanique, ensemble de microsystème électromécanique sous vide comprenant un tel boitier, et procédé de détection d'un problème de brasure dans un tel ensemble.

Un microsystème électromécanique est un microsystème comprenant un ou plusieurs éléments mécaniques qui utilise l'électricité comme source d'énergie, en vue de réaliser une fonction de capteur et/ou d'actionneur avec au moins une structure présentant des dimensions micrométriques, et dont la fonction du système est en partie assurée par la forme de cette structure. Le terme systèmes microélectromécaniques est la version française de l'acronyme MEMS pour "Microelectromechanical systems" en langue anglo-saxonne. Dans la suite de la description, l'acronyme MEMS pourra être employé comme synonyme de systèmes microélectromécaniques.

Pour assurer le fonctionnement de détecteurs MEMS notamment résonant, tels des capteurs inertiels de types gyromètres ou accéléromètres, il faut qu'ils soient au sein d'une enceinte sous vide, plus ou moins poussé, afin de permettre le fonctionnement correct du détecteur MEMS mis en oeuvre, pour pouvoir disposer d'une sensibilité maximale du détecteur MEMS.

Ainsi, il est fréquent qu'une pression inférieure à 10⁻² millibars soit nécessaire au bon fonctionnement d'un tel détecteur. Ceux-ci sont donc encapsulés dans une enceinte hermétique, au sein de laquelle le vide requis ou une atmosphère à pression réduite a été réalisé.

Il est cependant difficile d'obtenir un niveau de vide de bonne qualité, ou, en d'autres termes, une pression faible, typiquement une pression inférieure à 10⁻² millibars à l'intérieur d'un boîtier de détecteur MEMS sur silicium. Pour palier ce problème, le vide est souvent obtenu par son conditionnement ou "packaging" en langue anglo-saxonne.

Un exemple de processus pour mettre sous vide des MEMS est l'utilisation de boîtier en céramique de type HTCC pour l'expression anglo-saxonne "High Température Cofired Céramique", mieux adaptée qu'un autre type de boîtier céramique de type LTCC pour l'expression anglo-saxonne "Low Température Cofired Ceramic".

Généralement on utilise des boîtiers HTCC de type LCC pour l'expression anglo-saxonne "Leadless Chip Carrier" sans broches, mais des boîtiers avec broches peuvent être utilisés. La fermeture sous vide s'effectue généralement par brasage d'un capot plat à l'aide d'une préforme de brasure classiquement à base d'or et d'étain (AuSn).

Le demande de brevet US2005/0167789 décrit un tel boîtier.

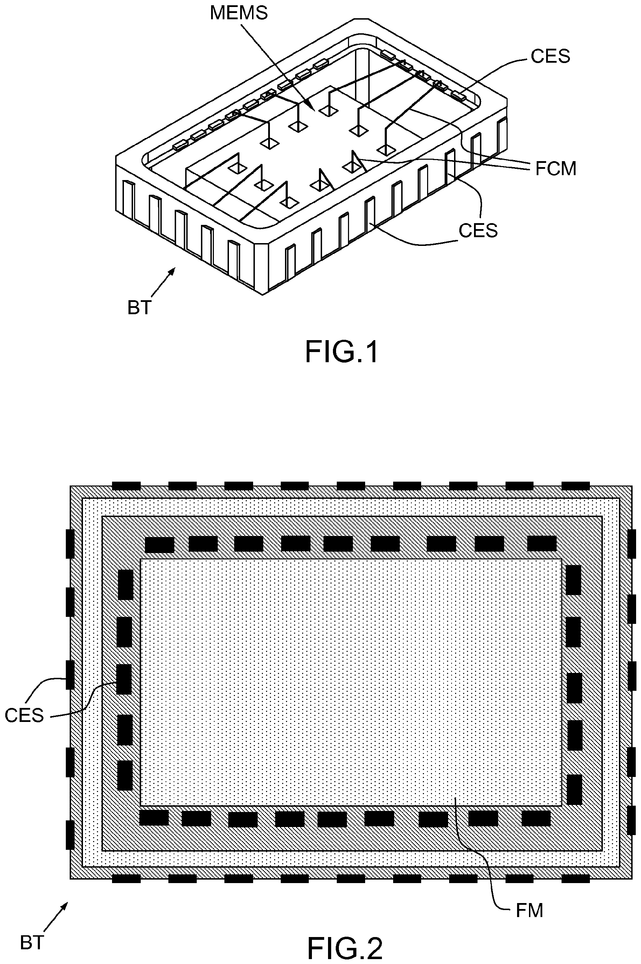

Les figures 1 et 2 illustrent un exemple schématique d'un boîtier de type LLC, dans lequel on n'a pas représenté le couvercle hermétique brasé au niveau de la face supérieure du boîtier BT.

Sur la figure 1, le boitier BT comprend un MEMS silicium relié électriquement à des contacts électrique de sortie CES du boîtier BT par des fils de câblage microélectriques FCM ou fils de "bonding" selon le terme anglo-saxon.

La figure 2 représente schématiquement une vue de dessus du boîtier BT dépourvu de MEMS sur lequel on visualise un fond métallisé FM adapté pour être lié audit microsystème électromécanique par brasure. Le boîtier BT comprend également des contacts électriques de sortie CES reliant électriquement l'intérieur et l'extérieur du boîtier.

La plupart des puces MEMS en silicium ont leurs sorties électriques sur la face supérieure et ont un substrat plan sur la face inférieure. Ce dernier servant à la fixation de la puce MEMS.

Afin d'obtenir un niveau de vide suffisant, il est nécessaire d'éviter l'emploi de matériau tel des polymères, pouvant produire des gaz dans la cavité du boîtier BT. Cela exclut donc d'utiliser une colle pour fixer le détecteur MEMS sur le fond du boîtier BT.

Le détecteur MEMS est donc généralement fixé par brasage. Il est classique de faire une brasure au centre de la puce, mais cette solution nécessite une grande surface de brasure afin de réaliser une tenue mécanique correcte (tenue en choc, tenue lors du câblage filaire de type microélectronique ou "ball bonding en langue anglo-saxonne). Cette grande surface a l'inconvénient de créer des contraintes, dues aux dilatations différentielles entre le silicium, la brasure et le boitier BT en céramique qui n'ont pas le même coefficient de dilatation, dans le détecteur MEMS pouvant perturber son fonctionnement. Les brasures utilisées sont, par exemple, des mélanges d'or et d'étain AuSn, mais d'autres matériaux peuvent être utilisés, tels des alliages à base de Plomb ou d'Indium.

Une telle fixation peut engendrer régulièrement un problème d'alignement du microsystème électromécanique et du fond du boîtier.

Si on prend l'exemple d'une puce MEMS brasée en un point ou plot dans un boîtier de type LCC, par exemple un boîtier LLC32, cette brasure est faite sans visibilité et il n'y a aucun moyen visuel de contrôler que la bille de brasage a bien mouillé la plage métallisée de la puce MEMS. Un contrôle par Rayons X est ainsi nécessaire, suivant plusieurs angles pour permettre de détecter une non mouillabilité des billes de brasage, et donc un problème de brasure. Ce contrôle est donc délicat et coûteux pour un contrôle systématique en série.

Un but de 'invention est de pallier les précédents problèmes.

Il est proposé, selon un aspect de l'invention, un boîtier apte à encapsuler, par exemple sous vide, un microsystème électromécanique muni d'un élément conducteur électrique destiné à être brasée avec ledit boîtier. Le boîtier comprend un fond métallisé, adapté pour être lié audit microsystème électromécanique par brasage, et des contacts électriques de sortie reliés électriquement à des éléments de contacts électriques du microsystème électromécanique. Le fond métallisé comprend une pluralité de portions de surface métallisées, respectivement délimitées par une zone non métallisée d'arrêt de brasage et respectivement reliées au reste du fond métallisé par une piste métallisée de petite largeur par rapport à la largeur ladite portion correspondante, destinées à être brasées avec ledit microsystème électromécanique.

Notamment dans le cas de MEMS de grande précision, il est donc utile de braser la puce MEMS silicium par plusieurs petits plots de brasage répartis aux extrémités du fond du boîtier. Cela permet de réduire les contraintes générées mais également d'obtenir un auto-alignement latéral lors de la fusion des billes de brasage.

Selon un mode de réalisation, ledit fond métallisé comprend une pluralité de secteurs isolés électriquement entre-eux, un secteur comprenant au moins une desdites portions de surface métallisées et étant relié à un contact électrique de sortie par un conducteur électrique.

Un tel boîtier permettra à l'ensemble MEMS, qu'il formera après brasure, d'être testé en termes de brasures de manière aisée à réaliser et très peu coûteuse.

Dans un mode de réalisation, le boîtier comprend un couvercle hermétique brasé.

Selon un mode de réalisation, le rapport entre la largeur de ladite portion et la largeur de la piste associée est supérieur à un premier seuil et le rapport entre la longueur et la largeur de ladite piste est supérieur à un deuxième seuil.

Par exemple, ledit premier seuil est supérieur à 4 et ledit deuxième seuil est supérieur à 2.

Selon un mode de réalisation, un secteur comprend une seule portion de surface métallisée pour brasage.

Ainsi, dans l'ensemble MEMS, qu'il formera après brasure, il sera aisé et peu coûteux de savoir quelle brasure est défectueuse parmi les brasures liant le microsystème micromécanique au boîtier.

Par exemple ledit fond métallisé comprend 3 ou 4 secteurs isolés électriquement entre-eux.

Le rapport coût/qualité est alors très intéressant.

Selon un autre aspect de l'invention, il est également proposé un ensemble microsystème électromécanique sous vide comprenant un boîtier tel que précédemment décrit, ledit microsystème électromécanique étant fixé audit boîtier par des brasures entre lesdites portions de surface métallisée desdits secteurs et des parties métallisées correspondantes du microsystème électromécanique, disposées en vis-à-vis desdites portions sur l'élément conducteur électrique du microsystème électromécanique.

Un tel système permet, de manière très fiable d'avoir un excellent alignement du MEMS dans le boîtier.

Selon un autre aspect de l'invention, il est également proposé un procédé de détection d'un problème de brasure dans un ensemble microsystème électromécanique sous vide tel que décrit précédemment avec une pluralité de secteurs isolés électriquement entre-eux, un secteur comprenant au moins une desdites portions de surface métallisées et étant relié à un contact électrique de sortie par un conducteur électrique. Dans ce procédé, on teste les brasures entre le fond métallisé du boîtier et le microsystème électromécanique en vérifiant la continuité électrique entre un premier secteur du fond métallisé du boîtier, une brasure du premier secteur, l'élément conducteur électrique du microsystème électromécanique, une brasure d'un deuxième secteur du fond métallisé du boîtier, et le fond métallisé du deuxième secteur, à partir des contacts électriques de sortie du boîtier reliés électriquement respectivement aux premier et deuxième secteurs.

Un tel procédé permet à coût réduit de vérifier les brasures de l'ensemble microsystème électromécanique.

Selon un mode de mise en oeuvre, le procédé, appliqué à un ensemble microsystème électromécanique sous vide, le fond métallisé étant muni d'une pluralité de secteurs comprenant une seule portion de surface métallisée pour brasage, le procédé comprend une pluralité de tests par continuité électrique permettant de déterminer, en cas de détection d'un problème de brasure, la brasure défectueuse entre le fond métallisé du boîtier et le microsystème électromécanique.

Il est alors également possible, de déterminer, en cas de détection d'un problème de brasure, la brasure défectueuse entre le fond métallisé du boîtier et le microsystème électromécanique.

L'invention sera mieux comprise à l'étude de quelques modes de réalisation décrits à titre d'exemples nullement limitatifs et illustrés par les dessins annexés sur lesquels :
- les figures 1 et 2 illustrent schématiquement un boîtier apte à encapsuler sous vide un microsystème électromécanique selon l'état de la technique ;

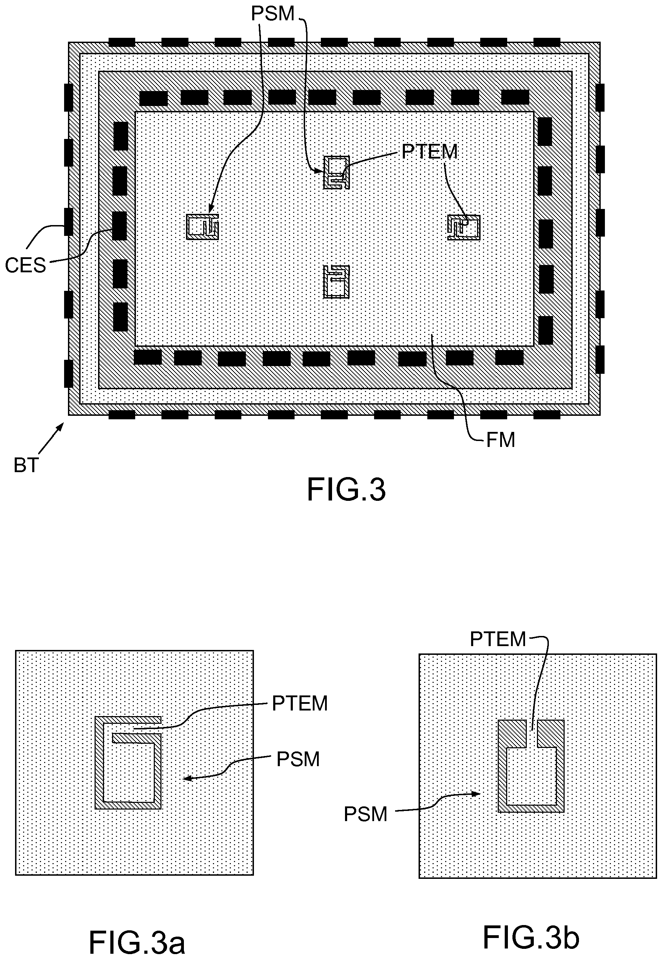

- la figure 3 illustre schématiquement un boîtier apte à encapsuler sous vide un microsystème électromécanique, selon un aspect de l'invention ;
- les figures 3a et 3b, illustrent deux autres modes de réalisation d'une piste métallisée reliant une portion isolée du fond métallisé au reste du fond métallisée ;

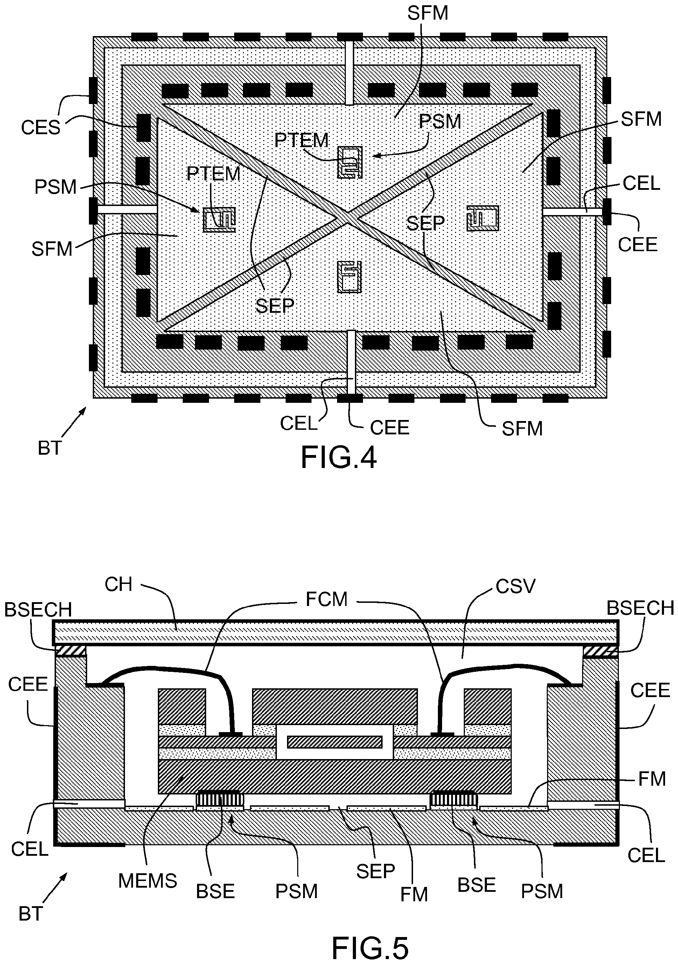

- la figure 4 illustre un boîtier apte à encapsuler sous vide un microsystème électromécanique, selon un autre aspect de l'invention ; et
- la figure 5 illustre un ensemble microsystème électromécanique sous vide comprenant un boîtier de la figure 4, selon un aspect de l'invention.

Sur l'ensemble de figures, les éléments ayants les mêmes références sont similaires.

Tel qu'illustré sur la figure 3, une vue de dessus d'un boîtier BT comprenant un fond métallisé FM comprend une pluralité de portions, en l'espèce 4, de surface métallisées PSM, respectivement délimitées par une zone non métallisée d'arrêt de brasage et respectivement reliées au reste du fond métallisé par une piste métallisée PTEM de petite largeur par rapport à la largeur ladite portion PSM correspondante, destinées à être brasées avec ledit microsystème électromécanique MEMS.

De manière préférentielle, le boîtier BT peut comprendre 3 ou 4 portions de surface métallisées PSM, correspondant au meilleur rapport entre la qualité d'alignement du MEMS avec le boîtier et le coût de brasage.

Le rapport entre la largeur d'une portion de surface métallisées PSM et la largeur de la piste métallisée PTEM associée est supérieur à un premier seuil S1 et le rapport entre la longueur et la largeur de ladite piste est supérieur à un deuxième seuil S2, le premier seuil est supérieur à 4 et le deuxième seuil est supérieur à 2. Par exemple, comme illustré, sur la présente figure, une piste métallisée PTEM a une forme de serpentin.

En variante, comme représenté sur les figures 3a et 3b, une piste métallisée PTEM peut, par exemple être avec un angle droit ou rectiligne.

Sur la figure 4, un boîtier BT selon un autre aspect de l'invention, dont le fond métallisé comprend une pluralité de secteurs SFM isolés électriquement entre-eux, un secteur SFM comprenant au moins une desdites portions de surface métallisées PSM, en l'espèce une seule portion de surface métallisée PSM, et étant relié à un contact électrique de sortie CEE par un conducteur électrique CEL.

La figure 5 représente un ensemble microsystème électromécanique MEMS sous vide comprenant un boîtier BT selon la figure 4, représenté en coupe. Ainsi l'ensemble microsystème électromécanique MEMS est fixé au boîtier BT par des brasures BSE. En outre, le couvercle hermétique CH est fixé au boîtier BT par des brasures BSECH.

Grâce à un boîtier de la figure 4, un ensemble microsystème électromécanique de la figure 5, peut être testé pour détecter un problème de brasure BSE entre le fond métallisé FM du boîtier BT et le microsystème électromécanique MEMS en vérifiant la continuité électrique entre un premier secteur SFM du fond métallisé FM du boîtier BT, une brasure BSE du premier secteur, l'élément conducteur électrique du microsystème électromécanique MEMS, une brasure BSE d'un deuxième secteur SFM du fond métallisé FM du boîtier, et le fond métallisé FM du deuxième secteur, à partir des contacts électriques de sortie CEE du boîtier reliés respectivement aux premier et deuxième secteurs par un conducteur électrique CEL respectif.

Ainsi, par un simple test de conduction électrique, il est possible de tester deux brasures BSE entre le microsystème électromécanique MEMS et le fond métallisé FM, bien moins coûteuse qu'un test par rayons X.

En outre, lorsqu'un secteur métallisé SFM comprend une seule portion de surface métallisée PSM pour brasage, le procédé comprend une pluralité de tests par continuité électrique permettant de déterminer, en cas de détection d'un problème de brasure BSE, la brasure défectueuse entre le fond métallisé FM du boîtier BT et le microsystème électromécanique MEMS.

## Revendications

1. Boîtier (BT) céramique apte à encapsuler hermétiquement et sous vide un microsystème électromécanique (MEMS) muni d'un élément conducteur électrique isopotentiel destiné à être brasé avec ledit boîtier (BT), ledit boîtier (BT) comprenant un fond métallisé (FM), adapté pour être lié audit microsystème électromécanique (MEMS) par brasage, et des contacts électriques de sortie (CES, CEE) aptes à être reliés électriquement à des éléments de contacts électriques dudit microsystème électromécanique, **caractérisé en ce que** ledit fond métallisé (FM) comprend une pluralité de portions de surface métallisées (PSM), respectivement délimitées par une zone non métallisée d'arrêt de brasage et respectivement reliées au reste du fond métallisé (FM) par une piste métallisée (PTEM) de petite largeur par rapport à la largeur ladite portion correspondante (PSM), destinées à être brasées avec ledit microsystème électromécanique (MEMS).

2. Boîtier (BT) selon la revendication 1, dans lequel ledit fond métallisé (FM) comprend une pluralité de secteurs (SFM) isolés électriquement entre-eux, un secteur (SFM) comprenant au moins une desdites portions de surface métallisées (PSM) et étant relié à un desdits contacts électriques de sortie (CEE) par un conducteur électrique (CEL).

3. Boîtier (BT) selon l'une des revendications précédentes, comprenant un couvercle hermétique (CH) brasé.

4. Boîtier (BT) selon l'une des revendications précédentes, dans lequel le rapport entre la largeur de ladite portion (PSM) et la largeur de la piste (PTEM) associée est supérieur à un premier seuil (S1) et le rapport entre la longueur et la largeur de ladite piste (PTEM) est supérieur à un deuxième seuil (S2).

5. Boîtier (BT) selon la revendication 4, dans lequel ledit premier seuil (S1) est supérieur à 4 et ledit deuxième seuil (S2) est supérieur à 2.

6. Boîtier (BT) selon la revendication 2, dans lequel un secteur (SFM) comprend une seule portion de surface métallisée (PSM) pour brasage.

7. Boîtier (BT) selon l'une des revendications 2 ou 6 dans lequel ledit fond métallisé (FM) comprend 3 ou 4 secteurs (SFM) isolés électriquement entre-eux.

8. Ensemble microsystème électromécanique sous vide comprenant un boîtier (BT) selon l'une des revendications 2, 6 ou 7 ledit microsystème électromécanique (MEMS) étant fixé audit boîtier (BT) par des brasures (BSE) entre lesdites portions de surface métallisée (PSM) desdits secteurs (SFM) et des parties métallisées correspondantes du microsystème électromécanique (MEMS), disposées en vis-à-vis desdites portions (PSM) sur l'élément conducteur électrique du microsystème électromécanique (MEMS).

9. Procédé de détection d'un problème de brasure dans un ensemble selon l'une des revendications 2 ou 6 à 8 dans lequel on teste les brasures (BSE) entre le fond métallisé (FM) du boîtier et un microsystème électromécanique (MEMS) encapsulé sous vide dans ledit boîtier en vérifiant la continuité électrique entre un premier secteur (SFM) du fond métallisé (FM) du boîtier (BT), une brasure (BSE) du premier secteur, l'élément conducteur électrique du microsystème électromécanique (MEMS), une brasure (BSE) d'un deuxième secteur (SFM) du fond métallisé (FM) du boîtier (BT), et le fond métallisé du deuxième secteur, à partir des contacts électriques de sortie (CEE) du boîtier (BT) reliés électriquement respectivement aux premier et deuxième secteurs.

10. Procédé selon la revendication 9, appliqué à un ensemble microsystème électromécanique sous vide selon l'une des revendications 2 à 8, dans lequel un secteur (SFM) comprend une seule portion de surface métallisée (PSM) pour brasage, le procédé comprend une pluralité de tests par continuité électrique permettant de déterminer, en cas de détection d'un problème de brasure (BSE), la brasure défectueuse entre le fond métallisé (FM) du boîtier (BT) et le microsystème électromécanique (MEMS).

## Patentansprüche

1. Keramisches Gehäuse (BT) zum luftdichten Einkapseln eines mikroelektromechanischen Systems (MEMS) unter Vakuum, das mit einem mit dem Gehäuse (BT) zu verlötenden isopotentialen elektrisch leitenden Element versehen ist, wobei das Gehäuse (BT) einen metallisierten Boden (FM) zum Lötverbinden mit dem mikroelektromechanischen System (MEMS) und elektrische Ausgangskontakte (CES, CEE) zum elektrischen Verbinden mit elektrischen Kontaktelementen des mikroelektromechanischen Systems umfasst, **dadurch gekennzeichnet, dass** der metallisierte Boden (FM) mehrere metallisierte Oberflächenteile (PSM) umfasst, die jeweils durch eine nicht metallisierte Lötstoppzone begrenzt und jeweils mit dem Rest des metallisierten Bodens (FM) durch eine metallisierte Bahn (PTEM) mit einer Breite verbunden sind, die gering ist im Vergleich zur Breite des entsprechenden Teils (PSM), bestimmt zum Verlöten mit dem mikroelektromechanischen System (MEMS).

2. Gehäuse (BT) nach Anspruch 1, wobei der metallisierte Boden (FM) mehrere Sektoren (SFM) umfasst, die elektrisch voneinander isoliert sind, wobei ein Sektor (SFM) wenigstens einen der metallisierten Oberflächenteile (PSM) umfasst und mit einem der elektrischen Ausgangskontakte (CEE) durch einen elektrischen Leiter (CEL) verbunden ist.

3. Gehäuse (BT) nach einem der vorherigen Ansprüche, das eine verlötete luftdichte Abdeckung (CH) umfasst.

4. Gehäuse (BT) nach einem der vorherigen Ansprüche, wobei das Verhältnis zwischen der Breite des Teils (PSM) und der Breite der assoziierten Bahn (PTEM) größer ist als eine erste Schwelle (S1) und das Verhältnis zwischen der Länge und der Breite der Bahn (PTEM) größer ist als eine zweite Schwelle (S2).

5. Gehäuse (BT) nach Anspruch 4, wobei die erste Schwelle (S1) größer ist als 4 und die zweite Schwelle (S2) größer ist als 2.

6. Gehäuse (BT) nach Anspruch 2, wobei ein Sektor (SFM) einen einzigen Teil einer metallisierten Fläche (PSM) zum Löten umfasst.

7. Gehäuse (BT) nach Anspruch 2 oder 6, wobei die metallisierte Basis (FM) 3 oder 4 Sektoren (SFM) umfasst, die elektrisch voneinander isoliert sind.

8. Mikroelektromechanische Systembaugruppe unter Vakuum, die ein Gehäuse (BT) nach Anspruch 2, 6 oder 7 umfasst, wobei das mikroelektromechanische System (MEMS) an dem Gehäuse (BT) durch Lötstellen (BSE) zwischen den Teilen der metallisierten Oberfläche (PSM) der Sektoren (SFM) und den entsprechenden metallisierten Teilen des mikroelektromechanischen Systems (MEMS) befestigt ist, angeordnet gegenüber den Teilen (PSM) auf dem elektrisch leitenden Element des mikroelektromechanischen Systems (MEMS).

9. Verfahren zum Erkennen eines Lötfehlers in einer Baugruppe nach einem der Ansprüche 2 oder 6 bis 8, wobei die Lötstellen (BSE) zwischen dem metallisierten Boden (FM) des Gehäuses und einem mikroelektromechanischen System (MEMS) geprüft werden, das in dem Gehäuse unter Vakuum eingekapselt ist, durch Prüfen der elektrischen Kontinuität zwischen einem ersten Sektor (SFM) des metallisierten Bodens (FM) des Gehäuses (BT), einer Lötstelle (BSE) des ersten Sektors, dem elektrisch leitenden Element des mikroelektromechanischen Systems (MEMS), einer Lötstelle (BSE) eines zweiten Sektors (SFM) des metallisierten Bodens (FM) des Gehäuses (BT), und dem metallisierten Boden des zweiten Sektors, auf der Basis der elektrischen Ausgangskontakte (CEE) des Gehäuses (BT), die elektrisch jeweils mit dem ersten und dem zweiten Sektor verbunden sind.

10. Verfahren nach Anspruch 9, angewandt auf eine mikroelektromechanische Systembaugruppe in einem Vakuum nach einem der Ansprüche 2 bis 8, wobei ein Sektor (SFM) einen einzigen metallisierten Flächenteil (PSM) zum Löten umfasst, wobei das Verfahren mehrere elektrische Kontinuitätstests beinhaltet, um im Falle der Erkennung eines Lötfehlers (BSE) die fehlerhafte Lötstelle zwischen der metallisierten Basis (FM) des Gehäuses (BT) und dem mikroelektromechansichen System (MEMS) zu ermitteln.

## Claims

1. A ceramic housing (BT) designed to hermetically encapsulate a microelectromechanical system (MEMS) in a vacuum, which system is provided with an isopotential electrical conducting element intended to be soldered with said housing (BT), said housing (BT) comprising a metallised base (FM) designed to be connected to said microelectromechanical system (MEMS) by soldering and electrical output contacts (CES, CEE) designed to be electrically connected to electrical contact elements of said microelectromechanical system, **characterised in that** said metallised base (FM) comprises a plurality of metallised surface portions (PSM) respectively delimited by a non-metallised soldering stop zone and respectively connected to the remainder of the metallised base (FM) by a metallised track (PTEM) that is narrower than the width of said corresponding portion (PSM) intended to be soldered with said microelectromechanical system (MEMS).

2. The housing (BT) according to claim 1, wherein said metallised base (FM) comprises a plurality of sectors (SFM) electrically isolated from each other, a sector (SFM) comprising at least one of said metallised surface portions (PSM) and being connected to one of said electrical output contacts (CEE) by an electrical conductor (CEL).

3. The housing (BT) according to any one of the preceding claims, comprising a soldered hermetically sealed cover (CH).

4. The housing (BT) according to any one of the preceding claims, wherein the ratio between the width of said portion (PSM) and the width of the associated track (PTEM) is greater than a first threshold (S1) and the ratio between the length and the width of said track (PTEM) is higher than a second threshold (S2).

5. The housing (BT) according to claim 4, wherein said first threshold (S1) is higher than 4 and said second threshold (S2) is higher than 2.

6. The housing (BT) according to claim 2, wherein a sector (SFM) comprises a single portion of metallised surface (PSM) for soldering.

7. The housing (BT) according to claim 2 or 6, wherein said metallised base (FM) comprises 3 or 4 sectors (SFM) electrically isolated from each other.

8. A microelectromechanical system assembly in a vacuum comprising a housing (BT) according to claims 2, 6 or 7, said microelectromechanical system (MEMS) being fixed to said housing (BT) by solder joints (BSE) between said portions of metallised surface (PSM) of said sectors (SFM) and the corresponding metallised parts of the microelectromechanical system (MEMS) disposed opposite said portions (PSM) on the electrical conducting element of the microelectromechanical system (MEMS).

9. A method for detecting a solder joint fault in an assembly according to claims 2 or 6 to 8, wherein the solder joints (BSE) are tested between the metallised base (FM) of the housing and a microelectromechanical system (MEMS) encapsulated in a vacuum inside said housing by checking the electrical continuity between a first sector (SFM) of the metallised base (FM) of the housing (BT), a solder joint (BSE) of the first sector, the electrical conducting element of the microelectromechanical system (MEMS), a solder joint (BSE) of a second sector (SFM) of the metallised base (FM) of the housing (BT), and the metallised base of the second sector, on the basis of the electrical output contacts (CEE) of the housing (BT) that are electrically connected to the first and second sectors, respectively.

10. The method according to claim 9 applied to a microelectromechanical system assembly in a vacuum according to any one of claims 2 to 8, wherein a sector (SFM) comprises a single portion of metallised surface (PSM) for soldering, the method comprises a plurality of electrical continuity tests for determining, in the event of the detection of a solder joint (BSE) fault, the faulty solder joint between the metallised base (FM) of the housing (BT) and the microelectromechanical system (MEMS).
